# EUROPÄISCHE PATENTANMELDUNG

(11) **EP 1 291 908 A2**
(43) Veröffentlichungstag der Anmeldung: **12.03.2003**
(21) Anmeldenummer: 02015462.1
(22) Anmeldetag: 12.07.2002
(51) Int. Cl.: H01L 21/48, H01L 23/367

(54) **Verfahren zur Herstellung von Kühlkörpern**

(30) Priorität: 28.08.2001 DE 10141988
(71) Anmelder: Diels, Manfred, 58540 Meinerzhagen (DE)
(72) Erfinder: Diels, Manfred, 58540 Meinerzhagen (DE)
(74) Vertreter: Schröter & Haverkamp

(57) **Zusammenfassung**

Vorgeschlagen wird ein Verfahren zur Herstellung von aus mehreren stranggepreßten Teilprofilen 3, 4 aus einer Aluminiumlegierung bestehenden Kühlkörpern 1, bei dem an den Teilprofilen 3, 4 ausgebildete Nuten 312, 412, 430 und Stegleisten 321, 421, 433 jeweils ineinander gesteckt und in Querrichtung durch Druckbeaufschlagung verbunden werden. Dabei werden jeweils nach außen abstehende bzw. vorstehende Nutwandungen bzw. Stegleisten 321, 421, 433 eines Teilprofiles 3, 4 in entsprechenden Nuten eines benachbarten Teilprofiles 3, 4 nach innen gebogen und mit plastischer Verformung gedrückt zur formschlüssigen Verklammerung der jeweiligen in die zugehörige Nut eingreifende Stegleisten. In die Nuten 312, 412, 434 werden Drähte zwei aus reinst Aluminium oder einer Aluminiumlegierung eingelegt und beim Verpressen der Stegleisten 321, 421, 433 in die zugehörigen Nuten 312, 412, 434 plastisch verformt. Die Verbindungsstellen werden hier durch Flüssigkeit dicht. Die Verbindung wird in Längsrichtung sicherer gestaltet.

## Beschreibung

Aus der WO 97/27619 ist ein Verfahren zum Herstellen von aus mehreren Teilprofilen aus Metall bestehenden Kühlkörpern zum Anbau an Halbleiterbauelemente bekannt. Ebenso sind aus dieser Druckschrift Profile zur Herstellung solcher Kühlkörper und nach dem Verfahren hergestellte Kühlkörper zu entnehmen. Bei diesem bekannten Verfahren werden die entsprechend ausgebildeten Teilprofile, die insbesondere vorzugsweise als Strangpreßprofile hergestellt sind, mit an ihnen ausgebildeten Nuten und Stegleisten jeweils ineinander gesteckt und in Querrichtung durch Druckbeaufschlagung verbunden. Dabei werden nach außen abstehende bzw. vorstehende Nutwandungen bzw. Stegleisten der Teilprofile in entsprechende Nuten eines benachbarten Teilprofiles nach innen gebogen und mit plastischer Verformung gedrückt zur formschlüssigen Verklammerung der in die zugehörige Nut jeweils eingreifenden Stegleiste.

Es zeigt sich in der Praxis, daß nach diesem bekannten Verfahren hergestellte Kühlkörper nur dann eine ausreichend innige Verbindung der Teilprofile aufweisen, wenn die Wandstärken der ineinandergreifenden Stegleisten und Nuten ausreichend groß sind, wobei hohe Druckkräfte zu ihrer Verformung notwendig sind. Es zeigt sich außerdem, daß die entsprechenden Verbindungsstellen nicht flüssigkeitsdicht sind, so daß die Verwendung solcher Kühlkörper nur für die Durchführung von gasförmigen Kühlmitteln möglich ist.

Die Aufgabe der Erfindung besteht darin, ein Verfahren zur Herstellung solcher bekannter Kühlkörper aus Teilprofilen vorzuschlagen, mit dem eine flüssigkeitsdichte Verbindung der Teilprofile erreicht wird und eine ausreichend stabile Verbindung der Teilprofile bei möglichst geringen Wandstärken der Verbindungsabschnitte erzielbar ist.

Gelöst wird die Erfindungsaufgabe mit dem Verfahren mit den Merkmalen des Anspruchs 1. Durch das Einlegen von Drähten aus Reinstaluminium in den entsprechenden Nuten und das nachträgliche Verpressen dieser drähte zusammen mit den einzupressenden Stegleisten werden jeweils die Drähte plastisch verformt und fließen weitgehend ausfüllend in die noch vorhandenen Spalträume auf.

Der plastisch verformte Draht haftet durch Kaltschweißung fest an der Oberfläche der Profile und bewirkt dadurch eine festhaftende und dichtende Verbindung. Hierdurch erfolgt eine flüssigkeitsdichte Verbindung der Teilprofile in Profillängsrichtung von hoher Qualität, wodurch auch das gesamte Kühlprofil-Bauteil wesentlicher stabiler wird.

Die verhältnismäßig hohen Umformkräfte durch Roll- oder Druckwerkzeuge können verringert werden, da der einliegende weiche Draht eine leichtere plastische Verformung ermöglicht. Dies hat aber auch zur Folge, daß die Profile, die auch der Abstützung der Verformungskräfte dienen, leichter gebaut werden können, was neben der Gewichtseinsparung auch für die Wärmeübertragung von besonderer Bedeutung sein kann.

Vorzugsweise werden weichgeglühte Aluminiumdrähte mit einem Reinheitsgehalt von 99,9 % verwendet. Diese Drähte können einen Durchmesser von 1 - 1,5 mm besitzen und lassen sich dabei in den entstehenden Verbindungsspalten noch verpressen, ohne daß Drahtmaterial nach außen austritt.

Insgesamt zeigt es sich, daß die innigen Verbindungen der nach dem erfindungsgemäßen Verfahren hergestellten Kühlprofile im Bereich der Verbindungsstellen bessere Wärmedurchgangswerte aufweisen. Die hohen Preßkräfte bei der Ausbildung der Verbindungen lassen sich reduzieren.

Anhand eines prinzipiell abgebildeten Ausführungsbeispieles wird das erfindungsgemäße Verfahren erläutert. Es zeigen:
- **Fig. 1**: einen Querschnitt durch die Montageanordnung mehrerer Teilprofile vor der Verpressung der Verbindungsstellen und
- **Fig. 2**: einen entsprechenden Querschnitt der Anordnung in Figur 1 nach der Verpressung der nach außen abstehenden Stegleisten in die entsprechenden zugehörigen Nuten.

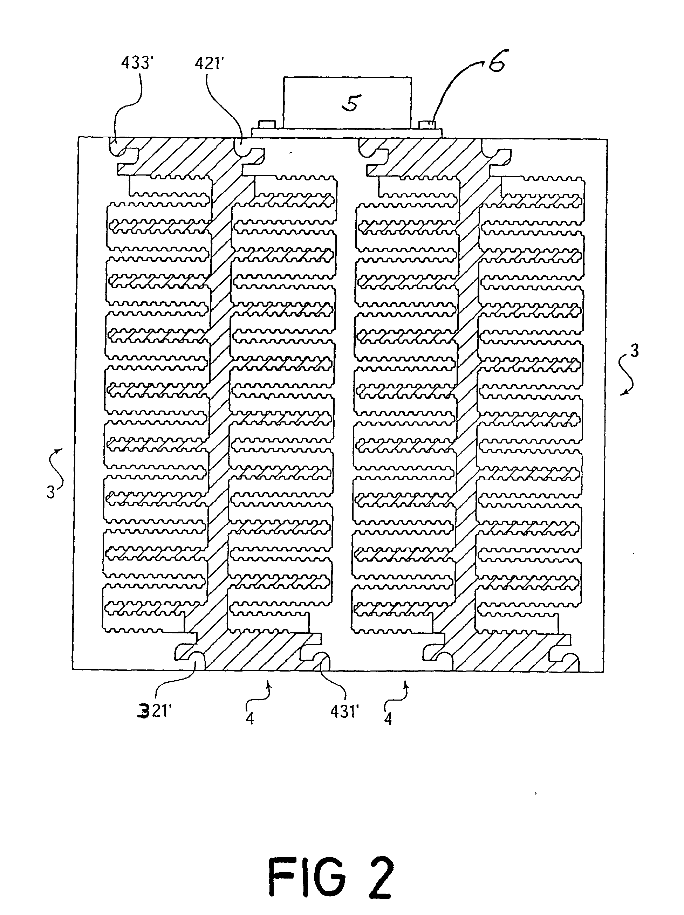

Mit der Ziffer 1 ist insgesamt ein Kühlkörper bezeichnet, der aus L-förmigen Teilprofilen 3 und etwa Z-förmigen weiteren Teilprofilen 4 herstellbar bzw. hergestellt ist. Wie aus Figur 2 ersichtlich ist ein solcher Kühlkörper 1 mit der Seite, die die Verbindungen aufweist nach entsprechender spanabhebender Bearbeitung an einem Halbleiterbauelement 5 mit einer Schraubverbindung 6 befestigt.

Die stranggepreßten Teilprofile 3 und 4 aus einer Aluminiumlegierung weisen in bekannter Weise zueinander parallele stegartige Kühlrippen auf, die Kühlflächen bilden im Inneren der einzelnen Kühlkammern.

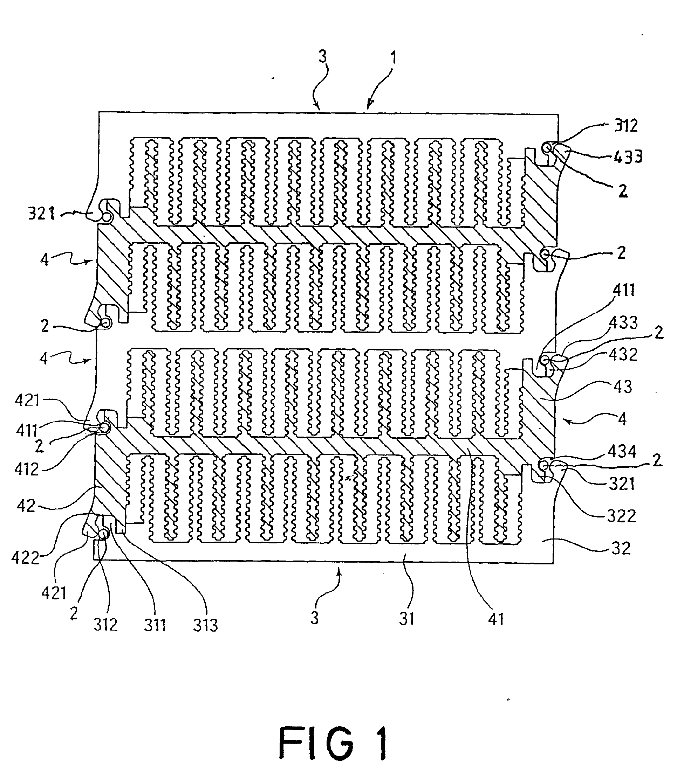

Die beiden außen liegenden L-förmigen Teilprofile 3 weisen an der Profilwand 31 am Ende eine Stegleiste 311 und unmittelbar benachbart die Nuten 312 und 313 auf. An der anderen Profilwand 32 ist stirnseitig eine Nut 322 ausgebildet, deren die Nutwand bildende Stegleiste 321 zunächst, wie in Figur 1 gezeigt, nach außen absteht. Die mit einem solchen Teilprofil verbindbaren anderen Teilprofile 4 bestehen aus der mittleren Profilwand 41 mit den senkrecht an beiden Seiten angeformten Kühlrippen und den endseitig angeordneten Profilwänden 42 und 43. Dabei sind stirnseitig an den Profilwänden 42 und 43 wiederum Nuten 422 und 432 vorgesehen, die von den nach außen abstehenden Stegleisten 421 bzw. 433 begrenzt werden. In diese Nuten 422 und 432 greifen jeweils die Stegleisten 311 und 411 benachbarter Teilprofile 3 bzw. 4 ein.

In die Nuten 312, 412 und 434 werden Drähte 2 aus Reinstaluminium eingelegt bzw. stirnseitig eingeschoben. Durch Verbiegen bzw. Verpressen der nach außen abstehenden Stegleisten 321 und 421 bzw. 433 in die Nuten 312, 412 bzw. 434 der benachbarten Teilprofile, beispielsweise durch Rollen oder Prägevorgänge, erfolgt gleichzeitig eine Verpressung der sehr weichen geglühten Drähte 2. Es erfolgt eine endgültige und innige Verklammerung der Teilprofile 3 und 4 miteinander, wobei die plastifizierten Drähte 2 sich in die verbleibende Spalte formen, so daß die Profile an diesen Verbindungsstellen vollständig flüssigkeitsdicht sind. Diese innige flüssigkeitsdichte Verbindung erhöht die Reibwerte, so daß die Profile in hohem Maße in Längsrichtung schubfest miteinander verbunden sind. Die Drähte sollten eine Stärke von 1 - 3 mm, vorzugsweise 1 - 1,5 mm haben.

Eine Verbindungsseite eines auf diese Weise hergestellten Hohlkammerprofiles 1 entsprechend Figur 2 bildet nach einer entsprechenden spanabhebenden Bearbeitung die ebene und glatte Kontaktfläche für ein mit der Ziffer 5 angedeutetes Halbleiterbauelement. In dieser Darstellung des fertigen Produktes sind die entsprechenden Nuten und die verpreßten Stegleisten jeweils mit den Ziffern 321', 431' und 433' angedeutet.

## Patentansprüche

1. Verfahren zur Herstellung von aus mehreren stranggepreßten Teilprofilen aus einer Aluminiumlegierung bestehenden Kühlkörpern zum Anbau an Halbleiterbauelementen, bei dem an den Teilprofilen (3, 4) ausgebildete Nuten (312, 412, 434) und Stegleisten (321, 421, 433) jeweils ineinander gesteckt und in Querrichtung durch Druckbeaufschlagung verbunden werden, wobei jeweils nach außen abstehende bzw. vorstehende Nutwandungen bzw. Stegleisten (321, 421, 433) eines Teilprofiles (3, 4) in entsprechende Nuten (312, 412, 434) eines benachbarten Teilprofiles (3, 4) nach innen gebogen und mit plastischer Verformung gedrückt werden zur formschlüssigen Verklammerung der jeweiligen in die zugehörige Nut eingreifenden Stegleiste, **dadurch gekennzeichnet, daß** in die Nuten (312, 412, 434) Drähte (2) aus Reinstaluminium oder einer Aluminiumlegierung eingelegt und beim Verpressen der Stegleisten (321, 421, 433) in die zugehörigen Nuten (312, 412, 434) plastisch verformt werden.

2. Verfahren nach Anspruch 1, **dadurch gekennzeichnet, daß** weich geglühte Aluminiumdrähte mit einem Reinheitsgehalt von 99,9 % verwendet werden.

3. Verfahren nach Anspruch 1 oder 2, **dadurch gekennzeichnet, daß** die verwendeten Drähte (2) einen Durchmesser von 1 - 1,5 mm aufweisen.
